# EUROPEAN PATENT APPLICATION

(11) **EP 3 422 422 A1**
(43) Date of publication of application: **02.01.2019**
(21) Application number: 17756075.2
(22) Date of filing: 26.01.2017
(51) Int. Cl.: H01L 31/0747, H01L 31/0216

(54) **SOLAR BATTERY CELL AND METHOD FOR MANUFACTURING SOLAR BATTERY CELL**

(30) Priority: 22.02.2016 JP 2016031090
(71) Applicant: Panasonic Intellectual Property Management Co., Ltd., Osaka-shi, Osaka 540-6207 (JP)
(72) Inventor: FUJITA Kazunori, Osaka-shi, Osaka 540-6207 (JP); FUJISHIMA Daisuke, Osaka-shi, Osaka 540-6207 (JP); TSUNOMURA Yasufumi, Osaka-shi, Osaka 540-6207 (JP); TAGUCHI Mikio, Osaka-shi, Osaka 540-6207 (JP); MASUKO Keiichiro, Osaka-shi, Osaka 540-6207 (JP)
(74) Representative: Müller-Boré & Partner Patentanwälte PartG mbB
(86) International application number: PCT/JP2017/002736
(87) International publication number: WO 2017/145633

(57) **Abstract**

According to one example of an embodiment of the present invention, a solar cell 10 is provided with: an n-type crystalline silicon wafer 11; a first passivation layer 12, which is formed on the light receiving surface of the n-type crystalline silicon wafer 11, and which is configured by having, as a main component, silicon oxide, silicon carbide, or silicon nitride; an n-type crystalline silicon layer 13 formed on the first passivation layer 12; a second passivation layer 16 formed on the rear surface of the n-type crystalline silicon wafer 11; and a p-type amorphous silicon layer 17 formed on the second passivation layer 16.

## Description

### TECHNICAL FIELD

The present disclosure relates to a solar cell and a solar cell manufacturing method.

### BACKGROUND

Solar cells having amorphous silicon layers formed on both surfaces of crystalline silicon wafers have been conventionally known. For example, Patent Literature 1 discloses a solar cell having an n-type amorphous silicon layer formed on a light receiving surface of a crystalline silicon wafer and having a p-type amorphous silicon layer formed on the rear surface of the wafer. The solar cell disclosed in Patent Literature 1 is provided with a transparent conductive layer and a collector electrode formed on the amorphous silicon layers, respectively.

### CITATION LIST

### PATENT LITERATURE

Patent Literature 1: JP 2006-237452 A

### SUMMARY

### TECHNICAL PROBLEM

In a solar cell, a problem of increasing an amount of light particularly incident on a light receiving surface side of a silicon wafer so as to improve the output characteristics of the cell is very important. In conventional technologies including Patent Literature 1, the shape of a collector electrode and the like have been devised to increase an amount of light incident on a light receiving surface side. However, further improvement is demanded.

### SOLUTION TO PROBLEM

A solar cell according to the present disclosure includes: a crystalline silicon wafer; a first passivation layer which is formed on a light receiving surface of the crystalline silicon wafer and which mainly contains silicon oxide, silicon carbide, or silicon nitride; an n-type crystalline silicon layer which is formed on the first passivation layer; a second passivation layer which is formed on a rear surface of the crystalline silicon wafer; and a p-type amorphous silicon layer which is formed on the second passivation layer.

A solar cell manufacturing method according to the present disclosure includes: a step of forming, on one surface of a crystalline silicon wafer, a first passivation layer which mainly contains silicon oxide, silicon carbide, or silicon nitride; a step of forming an n-type crystalline silicon layer on the first passivation layer; a step of forming a second passivation layer on the other surface of the crystalline silicon wafer on which the n-type crystalline silicon layer has been formed; and a step of forming a p-type amorphous silicon layer on the second passivation layer.

### ADVANTAGEOUS EFFECTS OF INVENTION

According to a solar cell as one aspect of the present disclosure, an amount of light incident on a crystalline silicon wafer is increased so that the output characteristics can be improved.

### BRIEF DESCRIPTION OF DRAWINGS

[FIG. 1] FIG. 1 is a sectional view of a solar cell as one example of an embodiment.
[FIG. 2] FIG. 2 is a flowchart showing a process for manufacturing the solar cell as the one example of the embodiment.
[FIG. 3] FIG. 3 is a sectional view of a solar cell as another example of the embodiment.
[FIG. 4] FIG. 4 is a flowchart showing a process for manufacturing the solar cell as the other example of the embodiment.
[FIG. 5] FIG. 5 is a sectional view of a solar cell as another one example of the embodiment.

### DESCRIPTION OF EMBODIMENTS

A solar cell according to the present disclosure includes an n-type crystalline silicon layer which is formed on a light receiving surface side of a crystalline silicon wafer. Therefore, an amount of light incident on the wafer is larger so that higher output characteristics can be obtained, compared to a conventional cell that has an amorphous silicon layer on a light receiving surface side. In addition, since a p-type amorphous silicon layer formed by a low temperature process is formed on the rear surface side of the crystalline silicon wafer, the output characteristics can be improved while the manufacturing cost is suppressed.

When the p-type crystalline silicon layer is formed on the rear surface side of the crystalline silicon wafer, diffusion of a p-type dopant such as boron (B) is expected to cause oxygen in the wafer and the boron to generate a complex defect so that the life time of a carrier may be decreased. As a method for inhibiting generation of such a complex defect, a wafer having a low oxygen concentration may be used, or heat treatment may be performed on a wafer at 1000°C or higher. However, in these cases, the manufacturing cost is greatly increased. That is, in the solar cell according to the present disclosure having an n-type crystalline silicon layer on a light receiving surface side of a crystalline silicon wafer and having a p-type crystalline silicon layer on the rear surface side of the crystalline silicon wafer, the manufacturing cost is low and high output characteristics are exerted. In addition, the solar cell has high uniformity in color, has good appearance, and has excellent durability.

Hereinafter, a detailed description is given of one example of an embodiment of the solar cell according to the present disclosure with reference to the drawings. Note that the solar cell according to the present disclosure is not limited to the following embodiment. The drawings which are referred to in the explanation of the embodiment are schematically illustrated, and dimensional ratios and the like among the components shown in the drawings should be determined while the following explanation is taken into consideration.

Regarding the wording "substantially ..." herein, a substantially entire region, for example, is intended to refer to a case of not only an entire region but also a region that is substantially regarded as the entire region. Furthermore, an n-type dopant refers to an impurity that functions as a donor, and a p-type dopant refers to an impurity that functions as an acceptor.

In the following embodiment, an n-type crystalline silicon wafer which is doped into an n-type is exemplified as a crystalline silicon wafer. Alternatively, a p-type crystalline silicon wafer which is doped into a p-type may be used as the crystalline silicon wafer. Also in this case, the same configuration may be adopted for first and second passivation layers, an n-type crystalline silicon layer, a p-type amorphous silicon layer, and the like, as the configuration in the case where an n-type crystalline silicon wafer is used.

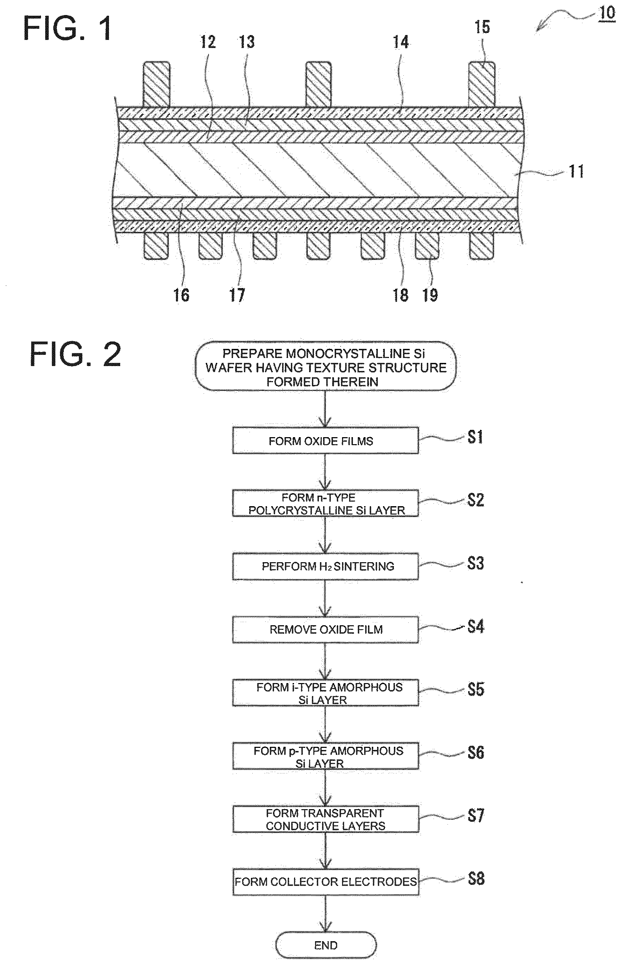

FIG. 1 is a sectional view of a solar cell 10 as one example of the embodiment. As illustrated in FIG. 1, the solar cell 10 includes an n-type crystalline silicon wafer 11, a first passivation layer 12 formed on the light receiving surface of the n-type crystalline silicon wafer 11, and an n-type crystalline silicon layer 13 formed on the first passivation layer. The solar cell 10 further includes a second passivation layer 16 formed on the rear surface of the n-type crystalline silicon wafer 11, and a p-type amorphous silicon layer 17 formed on the second passivation layer 16. Here, the "light receiving surface" of the n-type crystalline silicon wafer 11 refers to a surface on which most of available light (over 50 to 100%) is incident, and the "rear surface" refers to a surface opposite to the light receiving surface.

The crystallization rate of the p-type amorphous silicon layer 17 is lower than the crystallization rate of the n-type crystalline silicon layer 13. The crystallization rate of the n-type crystalline silicon layer 13 is lower than the crystallization rate of the n-type crystalline silicon wafer 11. The crystallization rates of the wafer and the layers are each measured on the basis of the area ratio, in a cross section of the wafer or layer as shown in FIG. 1, of a region where Si crystal lattices are observed with respect to a region of observation using a transmission electron microscope (TEM). That is, when the length, in the longitudinal direction, of the Si crystal lattice region is longer, the crystallization rate of the wafer or layer becomes higher. The n-type crystalline silicon wafer 11 is formed from monocrystalline silicon, and the n-type crystalline silicon layer 13 is formed from polycrystalline silicon, a detailed description of which is given later. A Si crystal lattice region formed in the p-type amorphous silicon layer 17 preferably has a longitudinal length of less than 2 nm.

The solar cell 10 includes a transparent conductive layer 14 formed on the n-type crystalline silicon layer 13, and a collector electrode 15 formed on the transparent conductive layer 14. The solar cell 10 further includes a transparent conductive layer 18 formed on the p-type amorphous silicon layer 17, and a collector electrode 19 formed on the transparent conductive layer 18. The transparent conductive layer 14 and the collector electrode 15 form a light receiving surface electrode for collecting electrons generated in the n-type crystalline silicon wafer 11. The transparent conductive layer 18 and the collector electrode 19 form a rear surface electrode for collecting holes generated in the n-type crystalline silicon wafer 11. The solar cell 10 has a pair of the electrodes formed on the light receiving surface side and the rear surface side of the n-type crystalline silicon wafer 11.

The n-type crystalline silicon wafer 11 may be an n-type polycrystalline silicon wafer, but is preferably an n-type monocrystalline silicon wafer. The n-type dopant concentration in the n-type crystalline silicon wafer 11 is 1×10¹⁴ to 1×10¹⁷ atoms/cm³, for example. The n-type dopant is not limited to a particular dopant, but phosphorus (P) is generally used therefor. The surface shape of the n-type crystalline silicon wafer 11 is a substantially square shape, one side of which is 120 to 160 mm. The thickness of the n-type crystalline silicon wafer 11 is 50 to 300 µm, for example. Examples of the substantially square shape include an octagonal shape which has two pairs of long sides parallel to each other and in which short sides and the long sides are alternately continuous to each other, for example. A wafer produced by a Czochralski method (Cz method) is generally used for the n-type crystalline silicon wafer 11, but a wafer produced by an epitaxial growth method may be used therefor.

The n-type crystalline silicon wafer 11 substantially does not contain a p-type dopant such as boron. However, a p-type dopant may be contained in an end surface of the n-type crystalline silicon wafer 11 or the surrounding area thereof. The p-type dopant concentration in the n-type crystalline silicon wafer 11 is 1×10¹⁴ atoms/cm³ or lower, which is lower than the detection limit 1×10¹⁵ atoms/cm³ in secondary ion mass spectrometry (SIMS). Since the p-type amorphous silicon layer 17 is formed by a low temperature process, substantially no boron diffuses from the p-type amorphous silicon layer 17 to the n-type crystalline silicon wafer 11. For this reason, a complex defect caused by diffusion of boron is not generated in the solar cell 10, so that decrease in the life time of a carrier due to such a defect does not occur.

In the n-type crystalline silicon wafer 11, the impurity concentration in an interface in contact with the first passivation layer 12 and the surrounding area of the interface is higher than the impurity concentration in an interface in contact with the second passivation layer 16 and the surrounding area of the interface. Hereinafter, the interface, of the n-type crystalline silicon wafer 11, in contact with the first passivation layer 12, is referred to as a "light receiving surface side interface", and the interface, of the n-type crystalline silicon wafer 11, in contact with the second passivation layer 16 is referred to as a "rear surface side interface", in some cases. Examples of the impurities contained in the n-type crystalline silicon wafer 11 include not only an n-type dopant such as phosphorus but also oxygen, nitride, and carbon. In the n-type crystalline silicon wafer 11, the oxygen concentration in the light receiving surface side interface and the surrounding area thereof is higher than the oxygen concentration in the rear surface side interface and the surrounding area thereof. The concentration of P, O, N, or C, etc. contained in the n-type crystalline silicon wafer 11 is measured by SIMS or TEM-energy dispersive X-ray spectrometry (TEM-EDX).

A texture structure (not illustrated) is preferably formed in a surface of the n-type crystalline silicon wafer 11. The texture structure refers to a recessed and projecting surface structure for suppressing surface reflection and increasing the light absorption amount of the n-type crystalline silicon wafer 11, and is formed in one of the light receiving surface and the rear surface, or in each of the light receiving surface and the rear surface. The texture structure can be formed by anisotropic etching of the (100) surface of a monocrystalline silicon wafer with use of an alkaline solution. A recessed and projecting structure having a pyramid shape is formed in a surface of the monocrystalline silicon wafer with an inclined surface of the pyramid shape being the (111) surface. The heights of the recesses and projections of the texture structure are 1 to 15 µm, for example.

The first passivation layer 12 is interposed between the light receiving surface of the n-type crystalline silicon wafer 11 and the n-type crystalline silicon layer 13, and inhibits recombination of carriers on the light receiving surface side of the cell. The first passivation layer 12 is formed on the substantially entire region of the light receiving surface of the n-type crystalline silicon wafer 11. In a case where the n-type crystalline silicon wafer 11 formed into a substantially square shape, one side of which is 120 to 160 mm, is used, the first passivation layer 12 formed on the substantially entire region may cover the entire surface of the substantially square shape, or may cover the entire surface excluding an outer peripheral region within 2 mm from the ends of the substantially square shape. The first passivation layer 12 preferably has such excellent thermostability that does not cause deterioration of passivation properties even when being exposed at high temperature.

The first passivation layer 12 preferably mainly contains silicon oxide (SiO₂), silicon carbide (SiC), or silicon nitride (SiN). The thickness of the first passivation layer 12 is 0.1 to 5.0 nm, for example. The thickness of the first passivation layer 12 is measured by observation of a cross section of the cell with use of a TEM (the same applies to the other layers).

When the first passivation layer 12 mainly contains silicon oxide, the oxygen concentration in the layer is preferably 1.0×10²¹ atoms/cm³ or higher. The oxygen concentration in the first passivation layer 12 is higher than that in the second passivation layer 16. In addition, the concentration of an n-type dopant such as phosphorus in the first passivation layer 12 is higher than the concentration of a p-type dopant such as boron in the second passivation layer 16. A process for forming the n-type crystalline silicon layer 13 is performed at temperature higher than temperature at which a process for forming the p-type amorphous silicon layer 17 is performed. For this reason, phosphorus in the n-type crystalline silicon layer 13 is easily diffused into the first passivation layer 12 while boron in the p-type amorphous silicon layer 17 is hardly diffused into the second passivation layer 16.

The n-type crystalline silicon layer 13 is formed on the light receiving surface of the n-type crystalline silicon wafer 11 via the first passivation layer 12. The n-type crystalline silicon layer 13 is formed on the substantially entire area of the light receiving surface of the n-type crystalline silicon wafer 11 via the first passivation layer 12. The thickness of the n-type crystalline silicon layer 13 is 5 to 20 nm, for example, and is preferably 8 to 15 nm.

The n-type crystalline silicon layer 13 is formed from polycrystalline silicon doped into an n type or microcrystalline silicon doped into an n type. The region of Si crystal lattices formed in the n-type crystalline silicon layer 13 has a length of 2 nm or longer in the longitudinal direction. When the region where Si crystal lattices can be observed falls within this range, a high solar light transmittance can be achieved. The absorption coefficient of the n-type crystalline silicon layer 13 in the wavelength range of 400 to 600 nm is lower than the absorption coefficient of the p-type amorphous silicon layer 17 in the same wavelength range. For example, the absorption coefficient of the n-type crystalline silicon layer 13 is 5×10⁴ to 4×10⁵ cm⁻¹ at the wavelength of 420 nm. The absorption coefficients of the layers can be obtained by ellipsometry.

The n-type dopant concentration in the n-type crystalline silicon layer 13 is 1×10²⁰ to 1×10²² atoms/cm³, for example, and is preferably 3×10²⁰ to 5×10²¹ atoms/cm³. The n-type dopant is not limited to a particular substance, but phosphorus is generally used therefor. The n-type dopant may be substantially uniformly contained in the n-type crystalline silicon layer 13. Alternatively, the n-type crystalline silicon layer 13 may have an n-type dopant concentration gradient. The resistivity of the n-type crystalline silicon layer 13 is higher than that of the transparent conductive layer 14, and is 0.1 to 150 mΩ·cm, for example.

The hydrogen concentration in the n-type crystalline silicon layer 13 is lower than that in the p-type amorphous silicon layer 17. In addition, the hydrogen concentration in the n-type crystalline silicon layer 13 is lower than that in the second passivation layer 16. The hydrogen concentration in the n-type crystalline silicon layer 13 is 1×10¹⁸ to 1×10²¹, for example, and is preferably 7×10¹⁸ to 5×10²⁰ atoms/cm³.

In a wavelength range of 355 to 405 nm, the refractive index of the n-type crystalline silicon layer 13 is preferably equal to or greater than 2.5 times the refractive index of the transparent conductive layer 14, and is 2.5 to 3.2 times, for example. The refractive indexes of the layers can be obtained by means of a spectroscopic ellipsometry device. When the refractive index of the n-type crystalline silicon layer 13 falls within the above range, color unevenness of the cell is reduced so that good appearance can be obtained.

The second passivation layer 16 is interposed between the rear surface of the n-type crystalline silicon wafer 11 and the p-type amorphous silicon layer 17, and inhibits recombination of carriers on the rear surface side of the cell. The second passivation layer 16 is formed on the substantially entire region of the rear surface of the n-type crystalline silicon wafer 11. When the n-type crystalline silicon wafer 11 formed into a substantially square shape, one side of which is 120 to 160 mm, is used, the second passivation layer 16 formed on the substantially entire region may cover the entire surface of the substantially square shape, or may cover the entire surface excluding an outer peripheral region within 2 mm from the ends of the substantially square shape. The second passivation layer 16 is preferably a layer that can be formed at a temperature of approximately 200°C, and has a thermostability lower than that of the first passivation layer 12. The preferable second passivation layer 16 is a layer containing substantially intrinsic amorphous silicon (hereinafter, referred to as "i-type amorphous silicon" in some cases) or amorphous silicon having a dopant concentration lower than that in the p-type amorphous silicon layer. The thickness of the second passivation layer 16 is larger than the thickness of the first passivation layer 12, and is 5 to 10 nm, for example.

The second passivation layer 16 preferably mainly contains i-type amorphous silicon, and may be an i-type amorphous silicon layer substantially containing i-type amorphous silicon only. The oxygen concentration in the second passivation layer 16 is lower than that in the first passivation layer 12, as described above, and the concentration of a p-type dopant such as boron in the second passivation layer 16 is lower than the concentration of an n-type dopant such as phosphorus in the first passivation layer 12.

The p-type amorphous silicon layer 17 is formed on the rear surface of the n-type crystalline silicon wafer 11 via the second passivation layer 16. The p-type amorphous silicon layer 17 is formed on the substantially entire region of the rear surface of the n-type crystalline silicon wafer 11 via the second passivation layer 16. Similar to the second passivation layer 16, the p-type amorphous silicon layer 17 formed on the substantially entire region may cover the entire surface of the substantially square shape or may cover the entire surface excluding the outer peripheral region within 2 mm from the ends of the substantially square shape. The thickness of the p-type amorphous silicon layer 17 is 1 to 25 nm, for example, and is preferably 1 to 10 nm.

The p-type dopant concentration in the p-type amorphous silicon layer 17 is 1×10²⁰ atoms/cm³ or higher, for example. The p-type dopant is not limited to a particular substance, but boron is generally used therefor. For example, boron is substantially uniformly contained in the p-type amorphous silicon layer 17. Note that the hydrogen concentration in the p-type amorphous silicon layer 17 is higher than that in the n-type crystalline silicon layer 13.

The transparent conductive layer 14 is formed on the substantially entire region of the light receiving surface side surface of the n-type crystalline silicon layer 13. Also, the transparent conductive layer 18 is formed on the substantially entire region of the rear surface side surface of the p-type amorphous silicon layer 17. When the n-type crystalline silicon wafer 11 formed into a substantially square shape, one side of which is 120 to 160 mm, each of the transparent conductive layers 14, 18 formed on the corresponding substantially entire regions may cover the entire surface of the substantially square shape or may cover the entire surface excluding the outer peripheral region within 2 mm from the ends of the substantially square shape. Further, transparent conductive layers 14, 18 may be formed on the n-type crystalline silicon layer 13 and the p-type amorphous silicon layer 17 formed to cover the entire surfaces of the substantially square shapes, respectively, such that the transparent conductive layers 14, 18 cover the entire surfaces excluding the outer peripheral regions within 2 mm from the ends of the respective substantially square shape. For example, the transparent conductive layers 14, 18 are formed from a transparent conductive oxide (IWO, ITO, etc.) obtained by doping tungsten (W), tin (Sn), or antimony (Sb), etc. to a metal oxide such as indium oxide (In₂O₃) or zinc oxide (ZnO). The thickness of each of the transparent conductive layers 14, 18 is preferably 30 to 500 nm, and is particularly preferably 50 to 200 nm.

Each of the collector electrodes 15, 19 preferably includes a plurality of finger sections and a plurality of bus bar sections. The finger sections are thin linear electrodes formed over wide ranges on the transparent conductive layers 14, 18. The bus bar sections are thin linear electrodes for collecting carriers from the finger sections, and are formed to be substantially orthogonal to the finger sections. The collector electrodes 15, 19 are formed by applying conductive pastes on the transparent conductive layers 14, 18, respectively, in a pattern including a large number of the finger sections and two or three of the bus bar sections, for example. The conductive pastes forming the collector electrodes 15, 19 may be obtained by dispersing conductive particles of 1 to 50 µm diameter made from silver, copper, nickel, or the like into a binder resin such as an acrylic resin, an epoxy resin, phenol novolac, or the like.

The collector electrode 19 is preferably formed so as to have an area larger than the area of the collector electrode 15. More finger sections are formed on the collector electrode 19 than the number of finger sections on the collector electrode 15. Accordingly, the area of the transparent conductive layer 18 covered with the collector electrode 19 is larger than the area of the transparent conductive layer 14 covered with the collector electrode 15. Furthermore, the collector electrode 15 is formed to be thicker than the collector electrode 19. However, the electrodes are not limited to particular structures, and a metallic layer may be formed, as a collector electrode of the rear surface electrode, on the substantially entire region of the transparent conductive layer 18.

FIG. 2 is a flowchart showing one example of a process for manufacturing the solar cell 10. The process for manufacturing the solar cell 10 comprises the following steps:
(1) A step of forming, on one surface of the n-type crystalline silicon wafer 11, the first passivation layer 12 which mainly contains silicon oxide, silicon carbide, or silicon nitride.
(2) A step of forming the n-type crystalline silicon layer 13 on the first passivation layer 12.
(3) A step of forming the second passivation layer 16 on the other surface of the n-type crystalline silicon wafer 11 on which the n-type crystalline silicon layer 13 has been formed.
(4) A step of forming the p-type amorphous silicon layer 17 on the second passivation layer 16.

In the example shown in FIG. 2, an oxide film that mainly contains silicon oxide is formed as the first passivation layer 12. In addition, at the step of forming the second passivation layer 16, a substantially intrinsic i-type amorphous silicon layer is formed to be thicker than the first passivation layer 12. Note that the second passivation layer 16 may be an amorphous silicon-containing layer having a p-type dopant concentration lower than that in the p-type amorphous silicon layer 17.

In the process for manufacturing the solar cell 10, the n-type crystalline silicon wafer 11 having a texture structure formed therein is first prepared, and silicon oxide films which are the first passivation layers 12 are formed on surfaces of the wafer (S1). For the n-type crystalline silicon wafer 11, an n-type monocrystalline silicon wafer is preferably used. The silicon oxide films are formed on both surfaces of the n-type monocrystalline silicon wafer. Examples of a method for forming the silicon oxide films include a steam oxidation method of performing heat treatment on an n-type monocrystalline silicon wafer having a texture structure formed therein in a high-pressure steam atmosphere at approximately 500°C, and a nitric acid oxidation method of immersing a wafer in nitric acid.

The silicon oxide film may be selectively formed on only one surface of the n-type crystalline silicon wafer 11. If so, an oxide film removing step (S4) (described later) can be omitted. Examples of such an oxidization method include a plasma/radical oxidation method and a method for forming a silicon oxide film (SiOx film) on one surface of the n-type crystalline silicon wafer 11 by CVD or sputtering, etc. The oxygen concentration in the SiOx film can be adjusted by change of the film formation condition.

For example, a SiOx film in which the oxygen concentration is set to be low is formed, and a surface of the SiOx film and the surrounding area of the surface are doped into an n type, so that the first passivation layer 12 and the n-type crystalline silicon layer 13 can be formed. Alternatively, an i-type amorphous silicon layer is formed on one surface of the n-type crystalline silicon wafer 11, and the i-type amorphous silicon layer is oxidized, so that the first passivation layer 12 can be formed.

Next, the n-type crystalline silicon layer 13 is formed on the silicon oxide film (S2). The n-type crystalline silicon layer 13 is formed by sputtering or CVD under a high temperature condition of 400 to 900°C, for example. In formation of the n-type amorphous silicon layer by CVD, a raw material gas obtained by adding phosphine (PH₃) to silane gas (SiH₄) and diluting the resultant gas by hydrogen, for example, is used. The dopant concentration in the n-type amorphous silicon layer can be adjusted by change of the phosphine mixture concentration. The n-type crystalline silicon layer 13 is formed as an n-type doped microcrystalline or polycrystalline silicon layer.

Next, hydrogen (H₂) sintering is performed on the n-type crystalline silicon wafer 11 on which the n-type crystalline silicon layer 13 has been formed (S3). Hydrogen sintering is performed by heat treatment of the n-type crystalline silicon wafer 11 at a temperature of approximately 350 to 450°C in a forming gas obtained by diluting hydrogen gas by inert gas such as nitrogen gas, for example. This step can particularly supplement hydrogen which has come out from the one surface and the surrounding area thereof in the n-type crystalline silicon wafer 11 exposed at high temperature during formation of the n-type crystalline silicon layer 13. Note that if the hydrogen concentration in the n-type crystalline silicon layer 13 is so high that no hydrogen needs to be supplemented, the hydrogen sintering step at S3 may be omitted.

Next, the silicon oxide film formed on the other surface of the n-type crystalline silicon wafer 11 is removed (S4), and then, an i-type silicon layer which is the second passivation layer 16 and the p-type amorphous silicon layer 17 are formed in order on the other surface of the wafer (S5, S6). The n-type crystalline silicon wafer 11 on the one surface of which the n-type crystalline silicon layer 13 has been formed is immersed in hydrofluoric acid (HF), whereby the silicon oxide film on the other surface of the n-type crystalline silicon wafer 11 is removed. At S4, for example, a natural oxide film formed on a surface of the n-type crystalline silicon layer 13 is also removed.

The n-type crystalline silicon wafer 11 that is clean is set in a vacuum chamber and CVD or sputtering is performed thereon so that the i-type amorphous silicon layer and the p-type amorphous silicon layer 17 are formed. To form the i-type amorphous silicon layer by CVD, a raw material gas obtained by diluting silane gas by hydrogen (H₂) is used, for example. For the p-type amorphous silicon layer 17, a raw material gas obtained by adding diborane (B₂H₆) to silane gas and diluting the resultant gas with hydrogen is used, for example. The dopant concentration in the p-type amorphous silicon layer 17 can be adjusted by change of the diborane mixture concentration.

Next, the transparent conductive layers 14, 18 are formed on the n-type crystalline silicon layer 13 and on the p-type amorphous silicon layer 17, respectively (S7). Thereafter, the collector electrodes 15, 19 are formed on the transparent conductive layers 14, 18, respectively (S8). The transparent conductive layers 14, 18 are formed by sputtering, for example. The collector electrodes 15, 19 are formed by applying conductive pastes containing silver (Ag) particles onto each transparent conductive layer by screen printing, etc., for example.

As described above, the solar cell 10 including the n-type crystalline silicon layer 13 and the p-type crystalline silicon layer 17 on the light receiving surface side and the rear surface side of the crystalline silicon wafer 11, respectively, can be manufactured at low cost and have high output characteristics. Furthermore, the solar cell 10 has no or little color unevenness, has good appearance, and also has excellent durability.

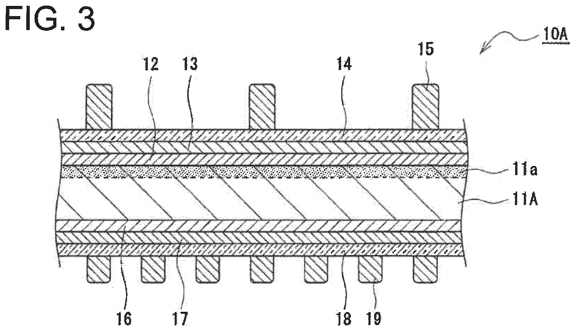

Hereinafter, as other examples of the embodiment, solar cells 10A, 30 are described with reference to FIGS. 3 to 5. In the following description, differences from the solar cell 10 are mainly explained.

FIG. 3 is a sectional view of the solar cell 10A as another example of the embodiment. As illustrated in FIG. 3, the solar cell 10A is different from the solar cell 10 in that the solar cell 10A has, at the interface in contact with the first passivation layer 12 of an n-type crystalline silicon wafer 11A and in the surrounding area thereof, an n⁺ layer 11a which is doped into an n type. The n⁺ layer 11a is formed by diffusing an n-type dopant such as phosphorus from a light receiving surface side of the n-type crystalline silicon wafer 11A, and has an n-type dopant concentration higher than that in the remaining region of the wafer. As a result of provision of the n⁺ layer 11a, the output characteristics of the cell are further improved. Note that a p-type dopant such as boron substantially does not exist in the n-type crystalline silicon wafer 11A, as in the solar cell 10.

For example, the n-type dopant concentration in the n⁺ layer 11a is 1×10¹⁷ to 1×10²⁰ atoms/cm³, and the n⁺ layer 11a is formed so as to have a thickness of 1 µm or smaller from the light receiving surface side interface of the n-type crystalline silicon wafer 11A. In other words, a region having a dopant concentration equal to or higher than the dopant concentration in the center portion, in the thickness direction, of the n-type crystalline silicon wafer 11A exists only within the thickness range of 1 µm or smaller from the light receiving surface of the n-type crystalline silicon wafer 11A. The n⁺ layer 11a generally has a concentration gradient such that the n-type dopant concentration decreases with increase in the depth, that is, with increase in the distance from the light receiving surface of the n-type crystalline silicon wafer 11A.

In the solar cell 10A, the n-type crystalline silicon layer 13 also have an n-type dopant concentration gradient. For example, the n-type crystalline silicon layer 13 has a concentration gradient in which the n-type dopant concentration increases toward the first passivation layer 12. Alternatively, the n-type crystalline silicon layer 13 has a concentration gradient in which the n-type dopant concentration decreases toward the first passivation layer 12.

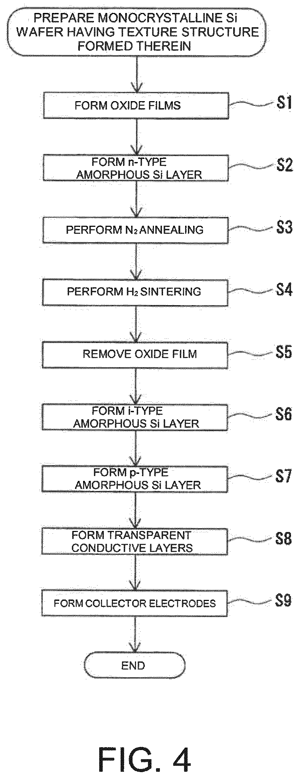

FIG. 4 is a flowchart showing one example of the process for manufacturing the solar cell 10A. As shown in FIG. 4, the process for manufacturing the solar cell 10A is different from the process for manufacturing the solar cell 10 in that, in the process for manufacturing the solar cell 10A, N₂ annealing treatment is performed (S3) after an n-type amorphous silicon layer is formed on a silicon oxide film (S2). As a result of the N₂ annealing, the n-type amorphous silicon layer is crystalized, and an n-type polycrystalline silicon which is the n-type crystalline silicon layer 13 is formed.

That is, in the process for manufacturing the solar cell 10A, after the amorphous silicon layer is formed, the amorphous silicon layer is crystalized to form the n-type crystalline silicon layer 13. In addition, before the second passivation layer 16 is formed after formation of the first passivation layer 12, the n⁺ layer 11a is formed by doping of the light receiving surface side interface of the n-type crystalline silicon wafer 11 and the surrounding area of the interface into an n type. In the example shown in FIG. 4, the n⁺ layer 11a is formed as a result of diffusion of an n-type dopant in the n-type amorphous silicon layer by N₂ annealing. The steps other than S2 and S3 are identical to those in the process for manufacturing the solar cell 10.

At S2, the n-type crystalline silicon wafer 11 on which silicon oxide films have been formed is set in a vacuum chamber, and an n-type amorphous silicon layer is formed by CVD or sputtering. In order to form a film of an n-type amorphous silicon layer by CVD, raw material gas obtained by adding phosphine to silane gas and diluting the resultant gas with hydrogen is used, for example.

S3 is a step of performing, under a nitrogen atmosphere at high temperature of approximately 800 to 900°C, heat treatment on the n-type crystalline silicon wafer 11 on which the n-type amorphous silicon layer has been formed. At S3, high-temperature and low-oxygen atmosphere annealing treatment may be performed with use of inert gas other than nitride, or laser annealing may be performed. This step facilitates crystallization of the n-type amorphous silicon layer, and thus, an n-type polycrystalline silicon layer, which is the n-type crystalline silicon layer 13, is formed. In addition, an n-type dopant such as phosphorus contained in the n-type amorphous silicon layer is diffused in the n-type crystalline silicon wafer 11, so that the n⁺ layer 11a is formed in the light receiving surface side interface and the surrounding area thereof.

The n⁺ layer 11a may be formed by a thermal diffusion method using phosphoryl chloride (POCl₃) vapor, etc. For example, an i-type amorphous silicon layer or a SiOx film in which the oxygen concentration is set to be low may be formed on one surface of the n-type crystalline silicon wafer 11, phosphorus may be thermally diffused at high temperature of approximately 800 to 900°C, and thereby the n⁺ layer 11a and the n-type crystalline silicon layer 13 can be formed. Alternatively, a SiOx film may be formed on one surface of the n-type crystalline silicon wafer 11, liquid silicon may be applied to the SiOx film, N₂ annealing treatment may be performed, and thereby the n-type crystalline silicon layer 13 can be formed.

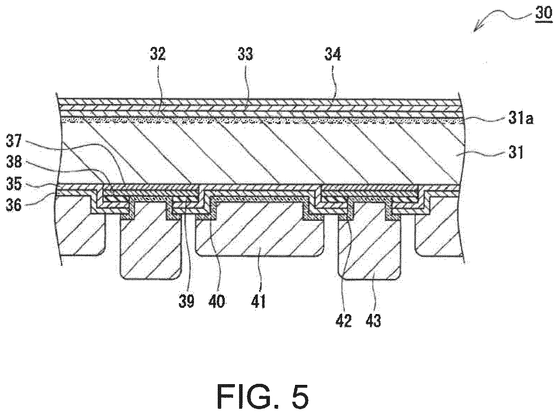

FIG. 5 is a sectional view of a solar cell 30 as another one example of the embodiment. As illustrated in FIG. 5, the solar cell 30 is different from the solar cells 10, 10A in that, in the solar cell 30, an electrode is provided only on the rear surface side of an n-type crystalline silicon wafer 31 whereas, in each of the solar cells 10, 10A, the electrodes are provided on the light receiving surface side and the rear surface side of the n-type crystalline silicon wafer. Similarly to the n-type crystalline silicon wafer 11A, the n-type crystalline silicon wafer 31 has, in the interface in contact with the first passivation layer 32 and the surrounding area thereof, an n⁺ layer 31a which is doped into an n type.

The solar cell 30 includes a first passivation layer 32 formed on the light receiving surface side of the n-type crystalline silicon wafer 31 and an n-type crystalline silicon layer 33 formed on the first passivation layer 32. The same configuration as those of the solar cell 10 or 10A can be adopted for the first passivation layer 32 and the n-type crystalline silicon layer 33. The solar cell 30 has a protective layer 34 on the n-type crystalline silicon layer 33. The protective layer 34 protects the n-type crystalline silicon layer 33, for example, and inhibits reflection of sun light on the surface of the cell. The protective layer 34 is preferably formed from a material having high light transmittance, and mainly contains an insulation material such as silicon oxide, silicon nitride, or silicon oxynitride.

The solar cell 30 includes second passivation layers 35, 37 formed on the rear surface side of the n-type crystalline silicon wafer 31, a p-type amorphous silicon layer 36, and an n-type amorphous silicon layer 38. The second passivation layer 35 is formed on the rear surface of the n-type crystalline silicon wafer 31, and is interposed between the n-type crystalline silicon wafer 31 and the p-type amorphous silicon layer 36. The second passivation layer 37 is formed on the rear surface of the n-type crystalline silicon wafer 31, and is interposed between the n-type crystalline silicon wafer 31 and the n-type amorphous silicon layer 38. The p-type amorphous silicon layer 36 and the n-type amorphous silicon layer 38 form, on the rear surface side of the n-type crystalline silicon wafer 31, a p-type region and an n-type region, respectively. Hereinafter, an explanation is given on the assumption that the second passivation layer 35 and the p-type amorphous silicon layer 36 form a p-type region and the second passivation layer 37 and the n-type amorphous silicon layer 38 form an n-type region.

The area of the p-type region formed on the rear surface of the n-type crystalline silicon wafer 31 is preferably larger than the area of the n-type region. The p-type region and the n-type region are formed in a comb-like pattern in which the p-type region and the n-type region are alternately arranged in one direction and mesh with each other in a plan view, for example. In the solar cell 30, a part of the p-type region overlaps a part of the n-type region, and the p-type region and the n-type region are formed over the rear surface of the n-type crystalline silicon wafer 31 without any space. On a portion where the p-type region and the n-type region overlap each other, an insulation layer 39 is provided between the regions. For example, the insulation layer 39 mainly contains silicon oxide, silicon nitride, silicon oxynitride, or the like. The insulation layer 39 may be formed from a material the same as the material of the protective layer 34.

The same configuration of the p-type amorphous silicon layer 17 of the solar cells 10, 10A can be adopted for the second passivation layers 35, 37. Also, the same configuration of the p-type amorphous silicon layer 17 of the solar cells 10, 10A can be adopted for the p-type amorphous silicon layer 36. The n-type amorphous silicon layer 38 is an amorphous silicon layer doped into an n type. The n-type dopant concentration in the n-type amorphous silicon layer 38 is 1×10²⁰ atoms/cm³ or higher, for example. An N-type dopant is generally contained in the n-type amorphous silicon layer 38 in a substantially uniform manner. The n-type dopant is not particularly limited to a specific substance, but phosphorus is generally used therefor. The hydrogen concentration in the p-type amorphous silicon layer 36 and the n-type amorphous silicon layer 38 is higher than that in the n-type crystalline silicon layer 33, and the densities of the p-type amorphous silicon layer 36 and the n-type amorphous silicon layer 38 are low.

The solar cell 30 includes a transparent conductive layer 40 and a collector electrode 41 formed on the p-type amorphous silicon layer 36, and a transparent conductive layer 42 and a collector electrode 43 formed on the n-type amorphous silicon layer 38. The transparent conductive layer 40 and the collector electrode 41 are p-side electrodes formed on the p-type region. The transparent conductive layer 42 and the collector electrode 43 are n-side electrodes formed on the n-type region. The transparent conductive layers 40, 42 are separated from each other at the position corresponding to the insulation layer 39. The collector electrodes 41, 43 are formed on the transparent conductive layers 40, 42, respectively. The collector electrodes 41, 43 may be formed by use of conductive pastes, but are preferably formed by electrolytic plating. The collector electrodes 41, 43 may be formed from metal such as nickel (Ni), copper (Cu), or silver (Ag) and may have a multilayer structure including an Ni layer and a Cu layer. In order to improve the corrosion resistance, each of the collector electrodes 41, 43 may have a tin (Sn) layer on the outer most surface.

In the solar cell 30, by the same method as in the solar cell 10A, for example, the first passivation layer 32, the n-type crystalline silicon layer 33, and the n⁺ layer 31a may be formed on the light receiving surface side of the n-type crystalline silicon wafer 31. The protective layer 34, the p-type region, the n-type region, the insulation layer 39, the transparent conductive layers 40, 42, and the collector electrodes 41, 43 may be formed by the same method as in a conventionally known solar cell having an electrode on the rear surface side thereof only. Similar to the solar cells 10, 10A, the solar cell 30 can be manufactured at low cost, has high output characteristics, has good appearance, and has excellent durability.

### REFERENCE SIGNS LIST

- 10, 10A, 30: solar cell
- 11, 11A, 31: n-type crystalline silicon wafer
- 11a, 31a: n⁺ layer
- 12, 32: first passivation layer
- 13, 33: n-type crystalline silicon layer
- 14, 18, 40, 42: transparent conductive layer
- 15, 19, 41, 43: collector electrode
- 16, 35, 37: second passivation layer
- 17, 36: p-type amorphous silicon layer
- 34: protective layer
- 39: insulation layer

## Claims

1. A solar cell comprising:
a crystalline silicon wafer;
a first passivation layer which is formed on a light receiving surface of the crystalline silicon wafer and which mainly contains silicon oxide, silicon carbide, or silicon nitride;
an n-type crystalline silicon layer which is formed on the first passivation layer;
a second passivation layer which is formed on a rear surface of the crystalline silicon wafer; and
a p-type amorphous silicon layer which is formed on the second passivation layer.

2. The solar cell according to claim 1, wherein
the second passivation layer contains substantially intrinsic amorphous silicon or amorphous silicon that has a dopant concentration lower than that in the p-type amorphous silicon layer, and is thicker than the first passivation layer.

3. The solar cell according to claim 1 or 2, wherein
a crystallization rate of the p-type amorphous silicon layer is lower than a crystallization rate of the n-type crystalline silicon layer, and
the crystallization rate of the n-type crystalline silicon layer is lower than a crystallization rate of the crystalline silicon wafer.

4. The solar cell according to any one of claims 1 to 3, wherein
the crystalline silicon wafer is an n-type crystalline silicon wafer, and has, at an interface in contact with the first passivation layer and a surrounding area thereof, an n⁺ layer that is doped into an n type and that has a dopant concentration higher than that in the remaining region.

5. The solar cell according to claim 4, wherein
in the crystalline silicon wafer, an impurity concentration in the interface in contact with the first passivation layer and the surrounding area thereof is higher than an impurity concentration in an interface in contact with the second passivation layer and a surrounding area thereof.

6. The solar cell according to claim 1, wherein
the first passivation layer mainly contains silicon oxide, and has an oxygen concentration higher than that in the second passivation layer.

7. The solar cell according to claim 6, wherein
the oxygen concentration in the first passivation layer is 1.0×10²¹ atoms/cm³ or higher.

8. The solar cell according to claim 7, wherein
the n-type crystalline silicon layer has a hydrogen concentration lower than that in the p-type amorphous silicon layer.

9. The solar cell according to claim 8, wherein
the n-type crystalline silicon layer has a hydrogen concentration lower than that in the second passivation layer.

10. The solar cell according to any one of claims 1 to 9, wherein
an n-type dopant concentration in the first passivation layer is higher than a p-type dopant concentration in the second passivation layer.

11. The solar cell according to claim 1, further comprising:
a first transparent conductive layer which is formed on the n-type crystalline silicon layer and which contains a metal oxide;
a first collector electrode which includes a plurality of thin linear finger sections formed on the first transparent conductive layer;
a second transparent conductive layer which is formed on the p-type amorphous silicon layer and which contains a metal oxide; and
a second collector electrode which is formed on the second transparent conductive layer.

12. The solar cell according to claim 11, wherein
a refractive index of the n-type crystalline silicon layer is equal to or greater than 2.5 times a refractive index of the first transparent conductive layer.

13. The solar cell according to claim 1, further comprising:
a protective layer which is formed on the n-type crystalline silicon layer and which mainly contains an insulation material;
a second transparent conductive layer which is formed on the p-type amorphous silicon layer and which contains a metal oxide; and
a collector electrode which is formed on the second transparent conductive layer.

14. A solar cell manufacturing method comprising:
a step of forming, on one surface of a crystalline silicon wafer, a first passivation layer which mainly contains silicon oxide, silicon carbide, or silicon nitride;
a step of forming an n-type crystalline silicon layer on the first passivation layer;
a step of forming a second passivation layer on the other surface of the crystalline silicon wafer on which the n-type crystalline silicon layer has been formed; and
a step of forming a p-type amorphous silicon layer on the second passivation layer.

15. The solar cell manufacturing method according to claim 14, wherein
the second passivation layer is formed to contain substantially intrinsic amorphous silicon or amorphous silicon having a dopant concentration lower than that in the p-type amorphous silicon layer and to be thicker than the first passivation layer.

16. The solar cell manufacturing method according to claim 14 or 15, wherein
the n-type crystalline silicon layer is formed by crystallization of an amorphous silicon layer after formation of the amorphous silicon layer on the first passivation layer.

17. The solar cell manufacturing method according to any one of claims 14 to 16, wherein
prior to formation of the second passivation layer after formation of the first passivation layer, an n⁺ layer is formed at an interface, of the crystalline silicon wafer, in contact with the first passivation layer and a surrounding area of the interface, by doping of the interface and the surrounding area thereof into an n type.
